# FASCICULE DE BREVET EUROPEEN

(11) **EP 2 104 139 B1**
(45) Date de publication et mention de la délivrance du brevet: **16.11.2011**
(21) Numéro de dépôt: 09155008.7
(22) Date de dépôt: 12.03.2009
(51) Int. Cl.: H01L 23/34, H01L 23/427

(54) **Dispositif de préchauffage d'un composant refroidi par conduction et/ou par convection**
Vorrichtung zum Vorheizen einer abgekühlten Komponente durch Wärmeleitung und/oder Konvektion
Device for preheating a cooled component by conduction and/or convection

(30) Priorité: 18.03.2008 FR 0801483
(43) Date de publication de la demande: 23.09.2009
(73) Titulaire: Kontron Modular Computers, Toulon Cedex (FR)
(72) Inventeur: Oconte, Philippe M., 83136, ROCBARON (FR); Tissot, Serge M., 83400, HYERES (FR); Ritondale, Michel M., 83390, CUERS (FR)
(74) Mandataire: Lucas, Laurent Jacques

(56) Documents cités:
- US-A- 5 645 123
- US-A- 5 896 259
- US-A1- 2004 093 887
- US-B1- 6 452 798

## Description

La présente invention concerne un dispositif de préchauffage d'un composant refroidi par conduction et/ou par convection. L'invention s'applique notamment au démarrage de composants soumis à des températures basses, par exemple les composants implantés dans des systèmes embarqués sur aéronefs.

Les composants électroniques, par exemple des processeurs de calcul, sont conçus pour fonctionner dans une plage limitée de températures, par exemple entre 0°C et 100°C. Aussi, lorsque ces composants fonctionnent, ils dégagent une quantité de chaleur qui doit être évacuée pour éviter de dépasser la limite haute de température autorisée. L'évacuation des calories produites par le composant est alors généralement effectuée grâce à des moyens de refroidissement par conduction ou par convection.

Dans certaines situations, notamment dans un grand nombre de systèmes embarqués, les composants sont placés dans des environnements en températures basses - par exemple -40°C -. Le dé marrage de ces composants à des températures inférieures à leur limite basse de température en fonctionnement pose problème. Pour élever la température au-delà de cette limite basse, il est possible par exemple, de placer une résistance chauffante à proximité du composant. Mais les moyens de refroidissement présents pour évacuer les calories en excès vont s'opposer à l'action de cette résistance chauffante, ralentissant ainsi, voire annihilant son effet. Il y a donc contradiction entre le besoin, à froid, de préchauffer le composant avant de le démarrer, et le besoin, à chaud, d'évacuer les calories produites par le composant.

A titre d'exemple, en prenant l'hypothèse d'un processeur de 15W de dissipation refroidi par conduction, il est nécessaire de préchauffer le processeur avec 74W de puissance pendant 9 minutes pour amener sa température de -40°C à 0°C. Cette durée d'attente e st souvent trop longue et cette puissance à fournir est généralement trop élevée pour être admissible dans les équipements embarqués.

On peut notamment citer dans le domaine du préchauffage de circuits électroniques, le brevet américain référencé sous le numéro US5896259 et issu d'une demande déposée pour Raytheon Company. Il est également connu le brevet américain référencé sous le numéro US5645123 et issu d'une demande déposée pour Kabushiki Kaisha Toshiba, ce brevet concernant des moyens de régulation de la température d'un composant électronique. Egalement, le brevet américain référencé sous le numéro US6452798 et issu d'une demande déposée pour Harris Corporation concerne un système de refroidissement dans lequel un fluide circule dans un circuit électronique. En outre, la demande de brevet américain référencée US2004/0093887 concerne un système de régulation de la température comprenant un circuit réfrigérant. Aucun de ces documents ne permet de résoudre le problème tel que décrit plus haut.

Un but de l'invention est de permettre à un composant associé à des moyens de refroidissement de démarrer dans un environnement dont la température est inférieure à sa température minimale de fonctionnement. A cet effet, l'invention a pour objet un dispositif de préchauffage d'un composant électronique en contact avec une pièce de conduction thermique, le dispositif comportant des moyens de chauffage de ladite pièce, le dispositif étant **caractérisé en ce qu'**il comprend au moins un caloduc reliant un dissipateur thermique avec ladite pièce, ledit dissipateur et ladite pièce étant par ailleurs thermiquement isolés l'un de l'autre.

En bloquant l'évacuation des calories par un effet de gel du fluide à l'intérieur du caloduc, le dispositif selon l'invention permet d'élever rapidement la température du composant afin de l'amener à un niveau acceptable avant sa mise en marche. De préférence, le volume de la pièce de conduction thermique est petit, de manière à limiter l'énergie nécessaire au préchauffage du composant.

La pièce de conduction thermique peut être formée par une excroissance du caloduc, de manière à réduire le volume de matériau à chauffer et à améliorer l'efficacité de conduction entre le caloduc et la pièce de conduction thermique.

Selon un mode de réalisation du dispositif selon l'invention, chaque extrémité du caloduc est placée en contact avec le dissipateur thermique, la partie centrale du caloduc étant en contact avec la pièce de conduction thermique. Ce mode de réalisation permet d'engendrer des chemins d'évacuation thermique sensiblement symétriques, ce qui facilite la conduction thermique, notamment lorsque le dispositif subit des accélérations gênant le déplacement du fluide contenu dans le caloduc.

Les moyens de chauffage peuvent comporter au moins une résistance chauffante, ladite résistance étant accolée à la pièce de conduction thermique.

Avantageusement, la pièce de conduction thermique et le caloduc sont calorifugés pour limiter les fuites thermiques.

En outre, la pièce de conduction thermique peut être arrondie en surface pour diminuer les fuites thermiques par rayonnement.

De préférence, la pièce de conduction thermique et le caloduc sont constitués de matériaux à chaleur massique faible, tels que, par exemple, l'aluminium ou le cuivre.

Selon un mode de réalisation du dispositif selon l'invention, le fluide de conduction thermique employé dans le caloduc peut être choisi pour que sa température de solidification soit au minimum égale ou légèrement en deçà (par exemple, quelques degrés Celsius de moins) de la température de préchauffage à atteindre.

Le dispositif selon l'invention peut par exemple être implanté dans un système embarqué fortement limité en puissance disponible et soumis à des températures basses.

D'autres caractéristiques apparaîtront à la lecture de la description détaillée donnée à titre d'exemple et non limitative qui suit faite en regard de dessins annexés qui représentent :
- la figure 1, une vue de dessus d'un mode de réalisation du dispositif selon l'invention ;
- la figure 2, une vue en coupe longitudinale du mode de réalisation de la figure 1 ;
- la figure 3, une vue en coupe transversale du mode de réalisation de la figure 1 ;
- la figure 4, une vue de la pièce de conduction thermique utilisée dans le mode de réalisation de la figure 1.

Les mêmes références dans des figures différentes désignent les mêmes éléments.

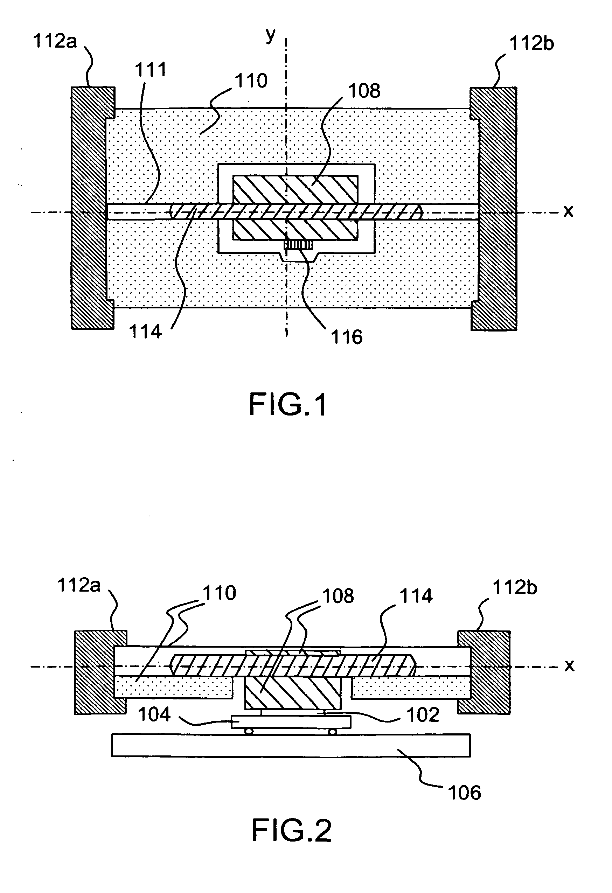

La figure 1, la figure 2 et la figure 3 présentent respectivement une vue de dessus, une vue en coupe longitudinale et une vue en coupe transversale d'un mode de réalisation du dispositif selon l'invention.

Le dispositif 100 de l'exemple comporte un composant 102 placé sur un substrat 104, lequel substrat 104 est disposé sur une carte de circuit imprimé 106. Une pièce de conduction thermique 108, par exemple un bloc en aluminium, est placée en contact avec le composant 102. Dans l'exemple des figures 1, 2 et 3, la pièce de conduction 108 est accolée à la face supérieure du composant 102.

Par ailleurs, un dissipateur thermique 110, par exemple un drain en aluminium, est enserré par des plaques froides 112a, 112b et placé à proximité du composant, sans le toucher. En outre, tout contact doit être évité entre la pièce de conduction 108 et le dissipateur thermique 110 afin qu'aucun chemin thermique direct entre la pièce de conduction 108 et le dissipateur thermique 110 ne soit créé. Dans l'exemple, le dissipateur thermique 110 est une plaque ajourée de sorte que la pièce de conduction 108 puisse passer au travers sans toucher la plaque.

Le dissipateur thermique 110 doit permettre d'évacuer une grande partie des calories produites par le composant 102. Aussi, un caloduc 114 relie le dissipateur thermique 110 à la pièce de conduction 108, de sorte que le caloduc 114 établit un chemin de conduction thermique efficace entre la pièce 108 et le dissipateur thermique 110 lorsque la température du caloduc 114 est suffisamment élevée pour permettre au fluide contenu dans le caloduc 114 de quitter la phase solide et d'opérer un circuit de conduction thermique. A contrario, lorsque la température du caloduc 114 est trop basse pour permettre une fusion du fluide, le circuit de conduction thermique à l'intérieur du caloduc 114 est impossible, ce qui isole thermiquement la pièce de conduction 108 du dissipateur thermique 110. Dans l'exemple, la face supérieure du dissipateur thermique 110 est rainurée 111 aux dimensions du caloduc 114 et le caloduc 114 est placé dans la rainure 111, la surface de contact entre le caloduc 114 et le dissipateur thermique 110 étant ainsi maximisée.

Afin d'élever la température du composant 102, une résistance chauffante 116 est placée à proximité d'icelui. Dans l'exemple, la résistance chauffante 116 est accolée à la pièce de conduction 108, mais dans un autre mode de réalisation, la résistance chauffante 116 est placée sur le caloduc 114.

La pièce de conduction thermique 108 joue notamment un rôle d'interface thermique. En effet, d'une part, elle achemine les calories issues de la résistance chauffante 116 vers le composant 102, et d'autre part, lorsque le composant 102 est en fonctionnement, la pièce de conduction thermique 108 achemine les calories issues du composant 102 vers le caloduc 114. Selon un mode de réalisation, la pièce de conduction thermique 108 n'est qu'une excroissance du caloduc 114, ladite excroissance 108 étant façonnée au moment de la fabrication du caloduc 114.

Lorsque dans un premier temps, le dispositif 100 est soumis à une température ambiante inférieure à la température de solidification du fluide contenu dans le caloduc 114 (à la pression interne du caloduc 114), la résistance chauffante 116 transmet des calories vers la pièce de conduction thermique 108, donc vers le composant 102 et le caloduc 114. Comme le fluide contenu dans le caloduc 114 est solidifié, le caloduc 114 est inopérant ; aussi, les calories demeurent en grande partie confinées à l'ensemble constitué du composant 102, de la pièce de conduction thermique 108 et du caloduc 114. La température de cet ensemble augmente jusqu'à atteindre la température minimale de fonctionnement du composant 102. Le composant peut alors être démarré sans risque, puis lorsque la température de l'ensemble { composant 102, pièce de conduction 108, caloduc 114 } atteint, voire dépasse la température de fusion du fluide, alors un circuit de conduction thermique peut s'effectuer dans le caloduc 114, lequel évacue alors les calories reçues vers le dissipateur thermique 110, évitant ainsi une surchauffe du composant 102.

Le fluide utilisé dans le caloduc 114 est, par exemple, de l'eau. Mais des fluides aux températures de solidification différentes peuvent être choisis pour s'adapter aux conditions d'utilisation du dispositif 100. Par exemple, pour des composants fonctionnant en températures très basses, l'alcool peut s'avérer être un choix judicieux pour le caloduc 114. Quelque soit le fluide choisi, sa température de solidification doit être inférieure à la température maximale de fonctionnement du composant 102.

Dans l'exemple, chaque extrémité du caloduc 114 est mise en contact avec le dissipateur thermique 110, la portion centrale du caloduc 114 étant en contact avec la pièce de conduction 108. Ainsi, le caloduc 114 de l'exemple comprend un évaporateur au niveau de la pièce de conduction 108 et deux condensateurs, un à chaque extrémité du caloduc 114. Cette configuration aboutit à l'obtention de deux chemins d'évacuation thermique sensiblement symétriques, ce qui réduit la distance de parcours du fluide d'un condensateur vers l'évaporateur et facilite par conséquent l'établissement d'un circuit thermique. Notamment, cette configuration améliore le chemin de conduction thermique opéré par le caloduc 114 lorsque le dispositif 100 subit des accélérations - dont la gravitation naturelle - gênant le déplacement du fluide.

Selon un autre mode de réalisation, une première extrémité du caloduc 114 est accolée à la pièce de conduction 108, tandis que sa seconde extrémité est placée en contact avec le dissipateur thermique 110, cette configuration aboutissant à un simple circuit évaporateur-condensateur.

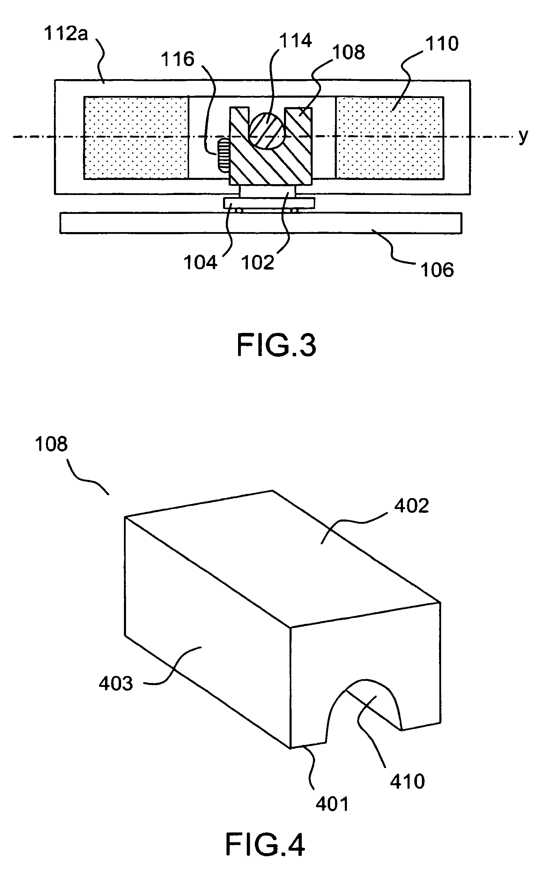

La figure 4 présente une vue de la pièce de conduction thermique utilisée dans le mode de réalisation de la figure 1.

La pièce de conduction 108 de l'exemple est en forme d'arche. Autrement dit, c'est un parallélépipède dont une face 401 a été évidée pour former une rainure 410 à la dimension du caloduc 114. La face opposée 402 à la face évidée est placée en contact avec le composant 102 (figures 1, 2, 3) et une face de côté 403 comprend une surface suffisante pour y placer une résistance chauffante.

Selon un autre mode de réalisation du dispositif selon l'invention, la pièce de conduction 108 peut être conformée de multiples manières, à condition notamment que la forme choisie permette une bonne conduction thermique entre ladite pièce 108, le caloduc 114 et le composant 102. Par ailleurs, plusieurs résistances chauffantes peuvent être accolées à la pièce de conduction 108 afin d'élever plus rapidement sa température.

Pour reprendre l'exemple cité en préambule de cette demande, avec une température environnante de -40°C et un processeur de 15W de dissipation refroidi par conduction, l'utilisation d'un dispositif selon l'invention permet de réduire la puissance nécessaire à fournir à 20W et la durée de préchauffage à 40 secondes pour amener sa température de -40°C à 0°C, contre 74W et 9 minutes nécessaires avec un dispositif classique, ce qui représente approximativement un gain (temps x puissance) d'un facteur 50.

Le dispositif selon l'invention peut être utilisé pour amener un composant à sa température minimale spécifiée, par exemple 0°C, avant sa mise sous tension ou avant son initialisation. Néanmoins, si la puissance disponible est très faible et/ou le temps acceptable pour le préchauffage est très court, le dispositif peut également être employé pour amener le composant à une température inférieure à la température spécifiée, par exemple -20°,- mais tout de même supérieure au fr oid ambiant -40°C-. Cette élévation limitée en température peut en effet suffire à atteindre un taux de succès acceptable lors d'un tri à froid de la carte équipée du composant.

Le dispositif selon l'invention s'applique de préférence aux composants électroniques présents sur des cartes refroidies par conduction. Toutefois, sans sortir du cadre de l'invention, le dispositif peut également s'appliquer aux cartes refroidies par convection en considérant qu'un mur froid peut être formé par un radiateur à convection associé au composant.

## Revendications

1. Dispositif de préchauffage d'un composant électronique (102) en contact avec une pièce de conduction thermique (108), le dispositif comportant des moyens de chauffage (116) de ladite pièce, le dispositif étant **caractérisé en ce qu'**il comprend au moins un caloduc (114) reliant un dissipateur thermique (110) avec ladite pièce, ledit dissipateur et ladite pièce étant par ailleurs thermiquement isolés l'un de l'autre.

2. Dispositif selon l'une quelconque des revendications précédentes, **caractérisé en ce que** la pièce de conduction thermique (108) est formée par une excroissance du caloduc (114).

3. Dispositif selon l'une quelconque des revendications précédentes, **caractérisé en ce que** les moyens de chauffage comportent au moins une résistance chauffante (116), ladite résistance étant accolée à la pièce de conduction thermique (108).

4. Dispositif selon l'une quelconque des revendications précédentes, **caractérisé en ce que** chaque extrémité du caloduc (114) est placée en contact avec le dissipateur thermique (110), la partie centrale du caloduc étant en contact avec la pièce de conduction thermique (108).

5. Dispositif selon l'une quelconque des revendications précédentes, **caractérisé en ce que** la pièce de conduction thermique (108) et le caloduc (114) sont calorifugés pour limiter les fuites thermiques.

6. Dispositif selon l'une quelconque des revendications précédentes, **caractérisé en ce que** la pièce de conduction thermique (108) est arrondie en surface pour diminuer les fuites thermiques par rayonnement.

7. Dispositif selon l'une quelconque des revendications précédentes, **caractérisé en ce que** la pièce de conduction thermique (108) et le caloduc (114) sont constitués de matériaux à chaleur massique faible.

8. Dispositif selon l'une quelconque des revendications précédentes, **caractérisé en ce que** le fluide de conduction thermique employé dans le caloduc (114) est choisi pour que sa température de solidification soit au minimum égale ou légèrement en deçà de la température de préchauffage à atteindre.

## Claims

1. A device for pre-heating an electrical component (102) in contact with a heat conducting part (108), the device comprising means for heating (116) said part, the device being **characterised in that** it comprises at least one heat pipe (114) linking a heat sink (110) to said part, said heat sink and said part also being thermally insulated from each other.

2. The device according to any one of the preceding claims, **characterised in that** the heat conducting part (108) is formed from a protuberance of the heat pipe (114).

3. The device according to any one of the preceding claims, **characterised in that** the heating means comprise at least one heating resistor (116), said resistor being placed on the side of the heat conducting part (108).

4. The device according to any one of the preceding claims, **characterised in that** each end of the heat pipe (114) is placed in contact with the heat sink (110), the central portion of the heat pipe being in contact with the heat conducting part (108).

5. The device according to any one of the preceding claims, **characterised in that** the heat conducting part (108) and the heat pipe (114) are insulated to limit heat loss.

6. The device according to any one of the preceding claims, **characterised in that** the heat conducting part (108) has a rounded surface to reduce heat loss by radiation.

7. The device according to any one of the preceding claims, **characterised in that** the heat conducting part (108) and the heat pipe (114) consist of material with low specific heat capacity.

8. The device according to any one of the preceding claims, **characterised in that** the heat conduction fluid used in the heat pipe (114) is selected so that its solidification temperature is at least equal to or slightly below the pre-heating temperature to be reached.

## Patentansprüche

1. Vorrichtung zum Vorheizen einer elektrischen Komponente (102) in Kontakt mit einem wärmeleitenden Teil (108), wobei die Vorrichtung Mittel (116) zum Heizen des Teils umfasst, wobei die Vorrichtung **dadurch gekennzeichnet ist, dass** sie wenigstens ein Wärmerohr (114) umfasst, das eine Wärmesenke (110) mit dem Teil verbindet, wobei die Wärmesenke und das Teil auch thermisch voneinander isoliert sind.

2. Vorrichtung nach einem der vorherigen Ansprüche, **dadurch gekennzeichnet, dass** der wärmeleitende Teil (108) von einem Fortsatz des Wärmerohrs (114) gebildet wird.

3. Vorrichtung nach einem der vorherigen Ansprüche, **dadurch gekennzeichnet, dass** die Heizmittel wenigstens einen Heizwiderstand (116) umfassen, wobei der Widerstand an den wärmeleitenden Teil (108) angefügt ist.

4. Vorrichtung nach einem der vorherigen Ansprüche, **dadurch gekennzeichnet, dass** jedes Ende des Wärmerohrs (114) mit der Wärmesenke (110) in Kontakt ist, wobei der mittlere Abschnitt des Wärmerohrs mit dem wärmeleitenden Teil (108) in Kontakt ist.

5. Vorrichtung nach einem der vorherigen Ansprüche, **dadurch gekennzeichnet, dass** der wärmeleitende Teil (108) und das Wärmerohr (114) wärmeisoliert sind, um Wärmeverluste zu begrenzen.

6. Vorrichtung nach einem der vorherigen Ansprüche, **dadurch gekenntzeichnet, dass** der wärmeleitende Teil (108) eine abgerundete Fläche hat, um Wärmeverluste durch Strahlung zu reduzieren.

7. Vorrichtung nach einem der vorherigen Ansprüche, **dadurch gekennzeichnet, dass** der wärmeleitende Teil (108) und das Wärmerohr (114) aus Material mit schwacher spezifischer Wärmekapazität bestehen.

8. Vorrichtung nach einem der vorherigen Ansprüche, **dadurch gekennzeichnet, dass** das im Wärmerohr (114) angewandte wärmeleitende Fluid ausgewählt wird, damit seine Erstarrungstemperatur mindestens gleich oder leicht unter der zu erreichenden Vorheiz-Temperatur liegt.
